# EUROPEAN PATENT SPECIFICATION

(11) **EP 2 554 626 B1**
(45) Date of publication and mention of the grant of the patent: **19.08.2015**
(21) Application number: 12190102.9
(22) Date of filing: 17.09.2010
(51) Int. Cl.: C09K 11/06, H01L 51/50, C09B 57/10, C09B 69/10, H01L 51/00, C08G 61/12

(54) **Electroluminescent materials and devices**
ELEKTROLUMINESZIERENDE MATERIALIEN UND VORRICHTUNGEN
MATIÈRES ÉLECTROLUMINESCENTES ET DISPOSITIFS CORRESPONDANTS

(30) Priority: 18.09.2009 GB 0916395
(43) Date of publication of application: 06.02.2013
(62) Divisional of application: 10766246.2
(73) Proprietor: Thorn Lighting Ltd, Spennymoor, Durham DL16 6HL (GB)
(72) Inventor: Williams, Geoff, Spennymoor, Durham DL16 6HL (GB); Monkman, Andrew P., Durham DH1 3LE (GB); Bryce, Martin R., Richmond, North Yorkshire DL11 7NW (GB); Lyons, Ben P., Durham DH1 3LE (GB); Vaughan, Helen L., Durham DH1 3LE (GB); Kamtekar, Kiran T., Bromsgrowe, B61 0DW (GB)
(74) Representative: Thun, Clemens

(56) References cited:
- WO-A1-2006/041263
- WO-A1-2007/132236
- JONGHEE LEE ET AL: "Phenothiazine-S,S-dioxide- and fluorene-based light-emitting polymers: Introduction of e--deficientS,S-dioxide into e--rich phenothiazine", JOURNAL OF POLYMER SCIENCE PART A: POLYMER CHEMISTRY, vol. 45, no. 7, 16 February 2007 (2007-02-16), pages 1236-1246, XP055082207, ISSN: 0887-624X, DOI: 10.1002/pola.21890
- T. ASHOK REDDY ET AL: "Preparation and properties of some cardopolyamides containing phenoxathiin-10,10-dioxide and phenoxaphosphine units", JOURNAL OF POLYMER SCIENCE PART A: POLYMER CHEMISTRY, vol. 25, no. 9, 1 September 1987 (1987-09-01), pages 2327-2334, XP055082347, ISSN: 0887-624X, DOI: 10.1002/pola.1987.080250901

## Description

The present invention relates to electroluminescent materials and devices.

Electroluminescence is a phenomenon whereby materials emit light in response to an electric current passed therethrough. This phenomenon is exploited, *inter alia,* in the manufacture and operation of organic light emitting diodes (OLEDs). OLEDs typically include an organic semiconducting material which comprise an organic small molecule and/or a polymer (e.g. an oligomer).

In a simple OLED configuration, a thin film comprising an organic light emitting material is sandwiched between an anode and a cathode. When a bias voltage is applied across the device, holes are injected into the highest occupied molecular orbital (HOMO) of the light emitting material and electrons are injected into the lowest unoccupied molecular orbital (LUMO). When the electrons and holes recombine, an exciton is formed which is able to decay radiatively, resulting in the emission of light. The colour of the light produced is dependent on the HOMO- LUMO bandgap of the material.

However, in order to improve stability and enhance device efficiency (photons of light emitted per injected charge) a multi-layered device is usually employed. Such devices incorporate layers of charge transporting material such as an electron transport material and/or a hole transporting material to affect the injection of charges into the light emitting material resulting in enhanced light emission. A number of materials have been described for use as electron and hole transporting materials (Kulkarni et al. Chem. Mater. 2004, 16: 4556 - 4573; Yan et al . Appl. Phys. Lett. 2004, 84: 3873 - 3875).

White organic light emitting devices (WOLEDs) have attracted increasing interest in recent years as their potential applications to full colour displays with the help of colour filters, in backlights for liquid crystal displays (LCDs) and in solid-state lighting (SSL) devices become apparent. Consequently, an efficient single-component OLED capable of white light emission is highly desirable.

A number of approaches have been described for achieving white emission from WOLEDs, such as using multi-layer device structures to get white light emission at the same time from two or more active layers which each emit a different colour light (Burrows et al. Appl . Phys. Lett. 1998, 73: 435 - 437; D'Andrade et al . Adv. Mater. 2002, 14: 147 - 151; Lee et al . Mater. Sci. Eng. , B, 2002, 95:24 - 28; Huang et al . Appl. Phys. Lett. 2002, 80: 2782 - 2784), devices comprising single-layers into which different fluorescent or phosphorescent dopants are dispersed into a host polymer (where a dopant is an impurity element added in low concentrations to alter the optical/electrical properties of a semiconductor material) (Kido et al. Appl. Phys. Lett. 1995, 67; 2281 - 2283; Mazzeo et al . , Synth Met. 2003, 139:675 - 677) or pixelated structures in which the three Red, Green and Blue active layers are patterned as a matrix array using precise shadow masking (Kido et al. Appl. Phys. Lett. 1995, 67; 2281 - 2283). However, the high band gap required for blue emissions has ensured that the production of efficient, long-lasting blue emitters has proved challenging.

A single layer structure WOLED is desirable since they lend themselves more readily to large scale production and low-cost manufacturing. However, the single layer fluorescent or phosphorescent doped WOLEDs that have been described above suffer from a number of drawbacks including variations in the CIE (Commission Internationale de l'Eclairage) co-ordinates of colour emission depending upon the applied bias voltage, rendering them less preferable for LCD backlight and other illumination purposes.

Over the last decade polyfluorenes (PF) have emerged as effective electroluminescent materials in the class of semiconductive organic conjugated polymers. Properties of PFs which render them suitable for electroluminescent applications include bright blue emission, high hole mobility, excellent thermal and chemical/electrochemical stability and easy tuneable properties through chemical modifications and co-polymerisations. However, the mobility and injection of electrons are much lower than that of holes in these materials, resulting in a greatly unbalanced transport of positive and negative carriers. This poor charge balance in the electroluminescent material leads to overall low efficiency of OLED devices based on PFs. A further problem inherent to PF materials is the formation of fluorene defects as a result of thermal-, photo-, or electrical degradation, which is frequently encountered in these materials, resulting in low emission bands.

Many different approaches have been used to mitigate these problems; among them is the introduction of either electron donor or electron acceptor moieties into the homopolymers (in the backbone, as side-chains or endcaps). In OLEDs, the introduction of such electron donor or electron deficient moieties represents an efficient way to modify the HOMO-LUMO levels of the polymers thus allowing improved electron/hole mobility of the material, decreased barriers of charge injection into the electroluminescent layer, and tuning of the colour emission, i.e. by reducing the LUMO energy at the interface of the electrode and the polymer it is possible to increase electron injection to balance the charges in the device and improve efficiency.

PFs, and indeed other conjugated polymer systems, may be synthesised by a number of methods, but are commonly made by one of the Suzuki polymerisation method or the Yamamoto polymerisation method. Each of these methods ensures a coupling of the conjugation systems of the monomer units.

Suzuki polymerisation effects the coupling of an aryl- or vinyl-boronic acid or ester with an aryl or vinyl halide to form a conjugated system. The reaction is catalysed by a palladium (0) complex such as tetrakis(triphenylphosphine)palladium(0) and is described in several review papers (such as Suzuki, A. J. Organometallic Chem. 1999, 576, 147-168). Its use in polymerisation for organic semiconductors is described in Sakamoto J. et al., Macrol. Rapid Commun., 2009, 30, 653-687.

Yamamoto polymerisation effects the coupling of aryl- or vinyl-magnesium halides with aryl- or vinyl-halides to form a conjugated system. The reaction is catalysed by nickel complexes and was first described by Yamamoto et al in Bull Chem. Soc. Jpn., 1978, 51, 2091. Its use in polymerisation for organic semiconductors is described in Yamamoto T. Prog. Polym. Sci., 1993, 17, 1153-1205.

Fluorene-based copolymers incorporating electron-deficient thiophene-S, S-dioxide moieties have been tested and did not demonstrate improved performance of LED over conventional PF homopolymers, showing low to moderate external EL efficiencies of 10⁻³ to 0.14% (Charas et al . Chem. Commun. 2001, 1216: Charas et al., J. Mater. Chem. 2002, 12:3523; Pasini et al., J. Mater. Chem. 2003, 13:807; Destri et al., Synth. Metals, 2003, 138, 289). Therefore, typically it is not expected that incorporation of a thiophene-S,S-dioxide moiety into a fluorene-based copolymer would be beneficial. In fact it is expected, and reported, that quenching of the emission occurs resulting in overall poor efficiency of OLED devices incorporating these materials.

Regular and random fluorene copolymers containing dibenzothiophene-2, 8-diyl (Yang et al. J. Mater. Chem. 2003, 13:1351 - 1356; Nemoto et al. J. Polym. Sex. A: Polym. Chem. 2003, 41:1521 - 1526) and PPV copolymers containing dibenzothiophene-S, S-dioxide-2, 8-diyl (Wang et al. Thin Solid Films 2003, 424:186 - 190; Wang et al . Synth. Metals 2003, 132:191 - 195) moieties in the main chain have been reported, which again showed from moderate to very low efficiency in OLED.

Again, these results would indicate that fluorene-based copolymers incorporating thiophene-S,S-dioxide units as conjugated polymers would lead to poor efficiencies in OLED.

Other approaches are shown e.g. in Jonghee Lee et al (Journal of polymer science part A: polymer chemistry, vol. 45, no. 7, 16, 16 February 2007, pp. 1236-1246). Jonghee Lee et al (2007)discloses an electroluminescent polymer of formula 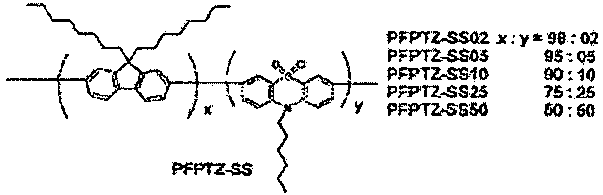 and OLEDs comprising such compounds (see Jonghee Lee et al (2007), abstract, page 1239). These electroluminescent polymers of Jonghee Lee et al (2007) have an emission efficiency that needed to be improved in view of increased requirement for light output in lighting devices and demanded decrease in energy consumption. Notably, Jonghee Lee et al (2007) focuses on unsubstituted N-Hexyl- phenothiazine-S,S-dioxide structures and polymers based thereon.

Furthermore, T. Ashok Reddy et al (Journal of polymer science part A: polymer chemistry, vol. 25, no. 9, 16, 1 September 1987, pp. 2327-2334) discloses polymers of formula 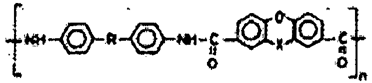 wherein X can be selected from SO₂ and R can be selected from fluorenyl. T. Ashok Reddy et al (1987) is silent on the feature that at least one of R¹ and R² and at least one of R³ and R⁴ is not H. T. Ashok Reddy et al (1987) is also silent on a definition of Y, wherein Y is not O when X is SO₂. Finally, T. Ashok Reddy et al (1987) does not define a second repeat unit.

In a first aspect, the invention provides an electroluminescent polymer comprising a first repeat unit comprising the structure: 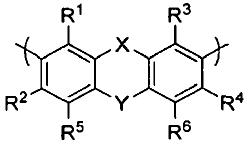 where R¹ to R⁶ are the same or different and comprise H or optionally substituted C₁ to C₂₆ straight or branched alkyl, alkenyl or alkynyl chains, alkoxy group; and wherein at least one of R¹ and R² and at least one of R³ and R⁴ is not H, where X comprises SO₂ and where Y comprises one of S, SO, SO₂, O, NR⁸, P or CR⁹R¹⁰, where R³ to R¹⁰ are the same or different and comprise H or optionally substituted C₁ to C₂₀ branched or cyclic alkyl, alkenyl or alkynyl chains or aryl groups,
wherein the polymer comprises a second repeat unit comprising an organic semiconducting moiety, wherein the second repeat unit preferably comprises the structure: 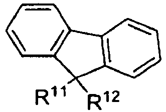 where R¹¹ and R¹² are the same or different and may comprise H or an optionally substituted C₁ to C₂₀ straight, branched or cyclic alkyl, alkenyl or alkynyl chain, aryl group, alkoxy group, amino, amido or hydroxyl groups, R¹¹ and R¹² being in particular C₈H₁₇.

Without wishing to be bound by any particular theory, the inventors have found that the inclusion of at least one substituent group at R¹ or R² and at least one substituent group at R³ or R⁴ provides sufficient steric effect to twist the first repeat unit with respect to the remainder of the polymer backbone. It is proposed that this twisting may cause a drop in the conjugation and increases the band gap of the material, thereby offering a deep blue emission spectrum.

Moreover, the inventors have surprisingly found that upon the inclusion of at least one substituent group at R¹ or R² and at least one substituent group or R³ or R⁴, an increase in emission efficiency is observed.

When referring to para-coupling and meta-coupling the ring structures are numbered such that carbon 1 is the carbon next to the atom or group of atoms with greatest molecular weight. Position 2 is "ortho", position 3 is "meta", and position 4 is "para".

Preferably R⁵ and/or R⁶ are H.

Preferably, at least three (*e.g*. all) of R¹ to R⁴ are not H.

Preferably, R¹ to R⁴, if not H, comprise C₁ to C₁₀ straight or branched alkyl alkenyl or alkynyl chains.

The polymer comprises a second repeat unit comprising an organic semiconducting moiety.

Preferably, the second repeat unit comprises the structure: 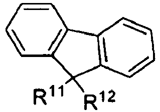 where R¹¹ and R¹² are the same or different and may comprise H or an optionally substituted C₁ to C₂₀ straight, branched or cyclic alkyl, alkenyl or alkynyl chain, aryl group, alkoxy group, amino, amido or hydroxyl groups.

Preferably, R⁴ and R⁵ comprise C₁ to C₁₀ unsubstituted straight alkyl chains.

Preferably, the second repeat unit is incorporated into the polymer backbone by para-coupling or meta-coupling.

Optionally, the copolymer or oligomer according to the first aspect further comprises at least one alkyne group. The at least one alkyne group can be situated between a first repeat unit and a second repeat unit or between two second repeat units.

In certain embodiments, the polymer may comprise a third repeat unit comprising an electron transport moiety. The electron transport moiety preferably comprises a structure selected from the group: 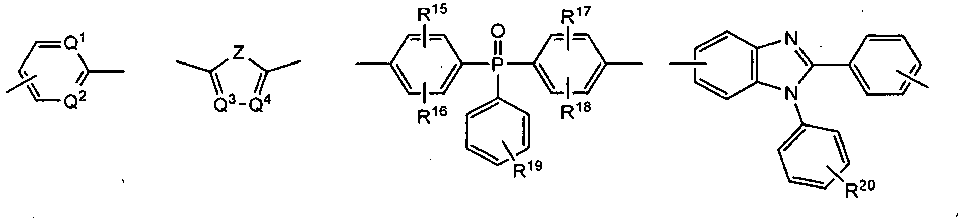 where R¹⁵ to R²⁰ may be the same or different and may comprise H or C₁ to C₁₀ (*e.g*. C₁ or C₅) optionally substituted, straight, branched or cyclic alkyl, alkenyl or alkynyl groups, nitro, amino, amido, halo, alkoxy, hydroxyl, thiol or thioalkyl; where Q¹ to Q⁴ may be the same or different and may comprise N or CH and where Z may comprise O, NR or S.

Preferably, the polymer comprises a fourth different repeat unit comprising a hole transport moiety.

Preferably, the hole transport moiety preferably comprises a structure selected from the group: 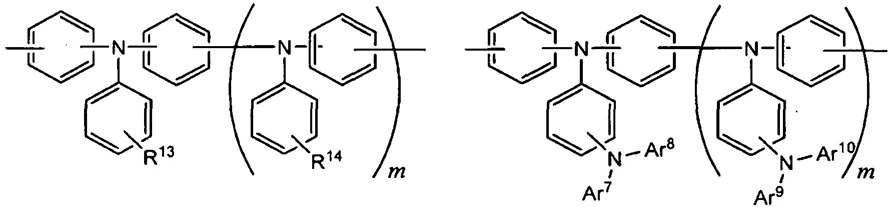 where R¹³ and R¹⁴ may be the same or different and may comprise H or C₁ to C₁₀ (*e.g*. C₁ or C₅) optionally substituted, straight, branched or cyclic alkyl, alkenyl or alkynyl groups, nitro, amino, amido, halo, alkoxy, hydroxyl, thiol or thioalkyl and where Ar⁷ to Ar¹⁰ comprise optionally substituted aryl groups.

Preferably, the polymer comprises a block copolymer, regular or alternating copolymer or a random copolymer, including the first repeat unit and one, some or all of the second, third and fourth repeat units.

Preferably, the copolymer is a random copolymer. The term "random copolymer" denotes a copolymer consisting of macromolecules in which the probability of finding a given monomeric unit at any given site in the chain is independent of the nature of the adjacent units.

The term "regular copolymer" denotes a copolymer comprising a sequence of regularly alternating repeating units.

The term "block copolymer" denotes a copolymer where each repeat unit is arranged to be adjacent at least one identical repeat unit.

In some embodiments the polymer further comprises one or more red and/or green emitting repeat units. Preferably the red and/or green emitting repeat units comprise phosphorescent emitters, such as those selected from complexes of the form IrL₃ or IrL₂X, where 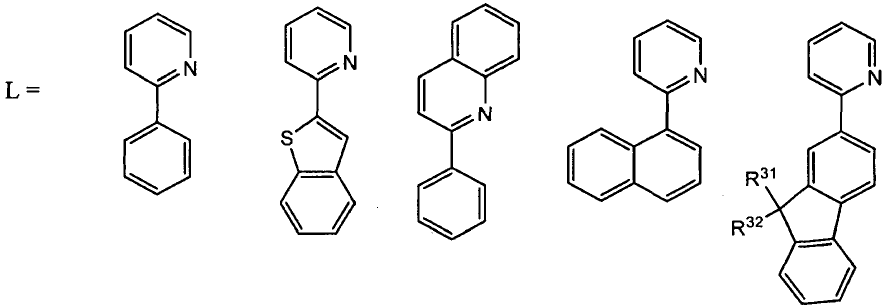 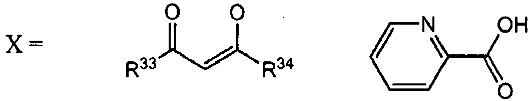 where R³¹ to R³⁴ may be the same or different and may comprise H or C₁ to C₁₀ (*e.g*. C₁ or C₅) optionally substituted, straight, branched or cyclic alkyl, alkenyl or alkynyl groups, nitro, amino, amido, halo, alkoxy, hydroxyl, thiol or thioalkyl; or complexes of the form:

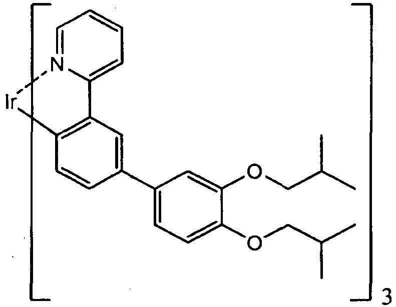

Alternatively or additionally, the polymer may comprise colour dopants, such as those selected from the group: 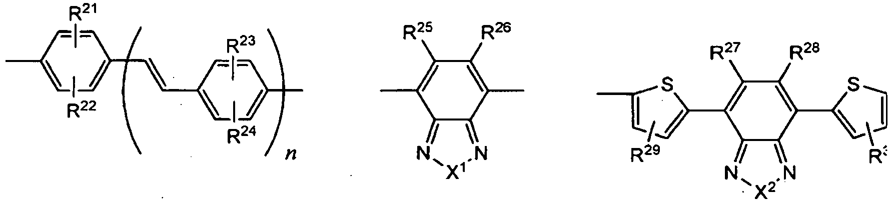 where R²¹ and R³⁰ may be the same or different and may comprise H or C₁ to C₁₀ (*e.g*. C₁ or C₅) optionally substituted, straight, branched or cyclic alkyl, alkenyl or alkynyl groups, nitro, amino, amido, halo, alkoxy, hydroxyl, thiol or thioalkyl and where X¹ and X² may comprise S or C₂H₄.

Optionally, the copolymer or oligomer according to the first aspect further comprises at least one alkyne group. The at least one alkyne group can be situated between a first repeat unit and a second repeat unit or between two second repeat units.

Preferably, the optionally first repeat units comprise approximately 2 - 50 mole percent of the polymer.

More preferably, the first repeat units comprise approximately 10 - 35 mole percent of the polymer.

More preferably, the first repeat units comprise approximately 20 - 30 mole percent of the polymer.

Preferably, at least a portion of the first repeat units functions as a blue emitting moiety.

Preferably, at least a portion of the first repeat units functions as an electron transporting moiety.

Preferably, at least a portion of the first repeat units functions as a high energy triplet host in the presence of one or more phosphorescent emitters (*e.g*. if the polymer comprises or is co-deposited with one or more phosphorescent emitters).

The first repeat units and the second repeat units are preferably selected such that they allow charge transfer therebetween in the excited state.

Preferably, the polymer is capable of emitting light close to white point as determined in the CIE (x,y = 0.33, 0.33).

The second repeat units may be substituted at any suitable position with any suitable functional group which results in a functionally equivalent molecule according to the present invention.

Preferably, when the second repeat units are substituted, they may be substituted at any suitable position with alkyl groups.

Optionally, when the second repeat units are substituted, they may be substituted at any suitable position by pendent moieties.

Optionally, when the second repeat units are substituted, they may be substituted at any suitable position by spiro units.

According to a second aspect of the invention there is provided an optical device comprising a polymer as described above.

Preferably, the optical device is an organic light emitting device whereby the polymer makes up at least part of an emissive layer.

Preferably, the organic light emitting device comprises first and second electrodes and the emissive layer is formed between the first and second electrodes.

Optionally, the organic light emitting device comprises at least one further layer, *e.g*. a hole injection layer or an electron injection layer.

Preferably, the copolymers of the invention are prepared by Suzuki polymerisation.

Optionally, the copolymers of the invention can be prepared by any suitable polymerization method, such as Yamomoto polymerization.

The inventors have advantageously established that simple OLED devices incorporating fluorene-based copolymers containing substituted dibenzothiophene-S,S-dioxide demonstrate improved electron transport and light emission over previously reported PF homopolymer devices resulting in improved external quantum efficiencies. The substituted dibenzothiophene-S,S-dioxide moiety also acts as an electron transporting moiety and in combination with the fluorene copolymer functions as a light emission moiety.

This is surprising as whilst thiophene dioxides are known as electron transport materials, heteroatoms are known not to be highly emissive due to quenching of the excited states. Therefore it would not be expected that the incorporation of substituted dibenzothiophene-S,S-dioxide into a fluorene-based copolymer would be highly emissive.

Accordingly, by virtue of this invention, the market for an alternative substantially white light source can be at least partially satisfied by a device comprising a light emitting surface incorporating a fluorene-based copolymer incorporating dibenzothiophene-S,S-dioxide units as described in the first aspect above.

A further advantage of the present invention derives from the increased solubility of the first repeat group afforded by the one or more substitutions. Embodiments of the present invention shall now be described in more detail with reference to the following drawings.
Figure 1 shows a synthesis of a monomer for forming a polymer as described herein;
Figure 2 shows a synthesis of a polymer as described herein;
Figure 3 shows photoluminescence data for the Polymer 1;
Figure 4 shows photoluminescence data for the Polymer 2;
Figure 5 shows readings for brightness against current density for a device according to Example 3;
Figure 6 shows readings for electroluminescent power against electroluminescent wavelength for a device according to Example 3;
Figure 7 shows current density against voltage for a device according to Example 3;
Figure 8 shows readings for brightness against current density for a device according to Example 4;
Figure 9 shows current density against voltage for a device according to Example 4;
Figure 10 shows readings for electroluminescent intensity against electroluminescent wavelength for a device according to Example 4 and a device according to Example 5;
Figure 11 shows readings for brightness against current density for a device according to Example 5;
Figure 12 shows current density against voltage for a device according to Example 5.

Random fluorene-dibenzothiophene-S, S-dioxide copolymers were synthesised by palladium-catalyzed Suzuki cross- coupling copolymerisation of 9, 9-dioctylfluorene comonomers and substituted dibromodibenzothiophene-S,S-dioxides as demonstrated in the examples below.

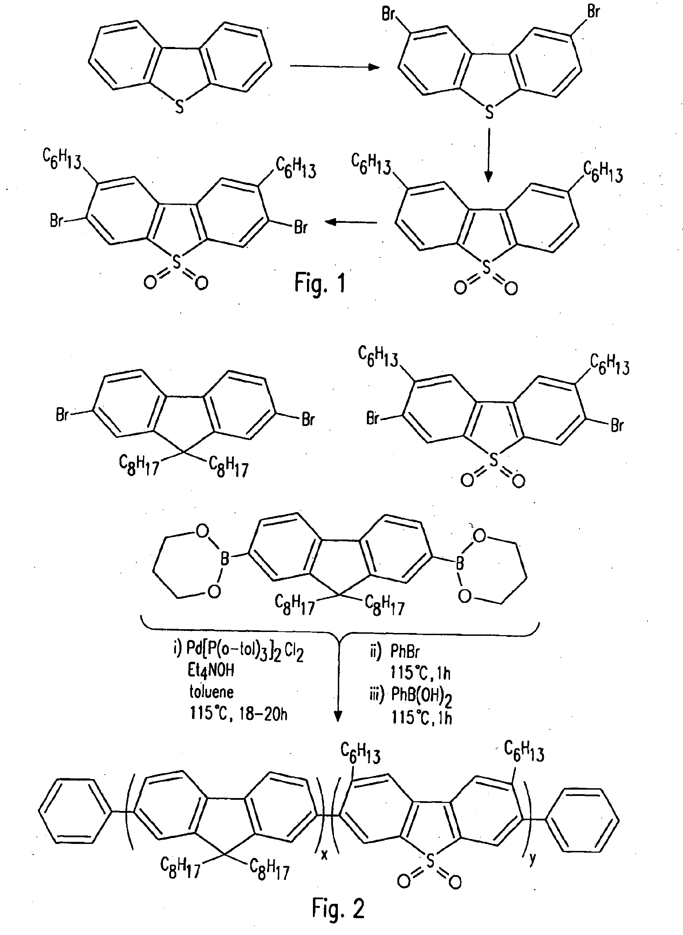

### Preparation of Monomer 1 (see Figure 1)

### Stage 1:

Dibenzothiophene (Aldrich or Alfa Aesar) (195 mmol) was dissolved in a 1:1 mixture of chloroform and acetic acid (both Fisher) (total 400 ml) under a protective atmosphere of argon and cooled in an ice bath. Bromine (Aldrich) (468 mol) in chloroform (25 ml) was added dropwise and the mixture was stirred overnight slowly rising to room temperature. The mixture was poured into methanol (Fisher) (500 ml) to precipitate the dibromodibenzothiophene product which was filtered and washed with methanol.

### Stage 2:

The dibromodibenzothiophene (29.3 mmol) was dissolved in tetrahydrofuran (THF) (Fisher) (200 ml) under a protective atmosphere of argon and cooled in a dry ice/acetone bath. n-Hexyllithium (Aldrich) (64.4 mmol) was added slowly and the solution was stirred for 3 h. Bromohexane (Aldrich) (71.2 mmol) was added and the solution was allowed to warm to room temperature overnight. The aqueous layer was extracted with diethyl ether (Fisher) and the combined organics were washed with water, dried, filtered and concentrated to yield an oil which was dissolved in acetic acid (Fisher) (50 ml). Hydrogen peroxide (Aldrich) (15 ml) was carefully added and the solution stirred at 140 °C for 2 h before a further 10 ml of peroxide was added and the solution was stirred at 140 °C overnight. Cooling water was added and the aqueous layer was extracted with chloroform. The organics were washed with water, dried, filtered and concentrated to yield an oil which was dissolved in ethanol. The flask was placed in the freezer overnight to crystallise the sulfone product.

### Stage 3:

The sulfone (13 mmol) was dissolved in H₂SO₄ (Fisher) (300 ml) and heated to 70 °C with protection from light. N-bromosuccinimide (NBS) (Aldrich) (29 mmol) was added in portions and the mixture stirred at 70 °C overnight. Analysis showed the presence of both monobromo and dibromo products so a further portion of NBS (5.6 mmol) was added and stirring continued overnight. Cooling water was added and the aqueous layer was extracted with chloroform and the organics were washed with water, dried, filtered and concentrated to yield an oil which was purified on silica eluting with DCM (Fisher):Petroleum ether 40-60 (Fisher) 1:1. The resulting solid was crystallised from ethanol.

### Example 1

### Synthesis of 70% fluorene - 30% Monomer 1 copolymer "Polymer 1" (Represented graphically in Figure 2).

A flask was charged with 9,9-dioctylfluorene-2,7-diboronic acid bis(1,3-propanediol) ester (400.0 mg, 99.50%, 0.713 mmol), 2,7-dibromo-9,9-dioctylfluorene (157.6 mg, 99.95%, 0.287 mmol), 3,7-dibromo-2,8-dihexyldibenzothiophene-S,S-dioxode (235.0 mg, 98.7%, 0.428 mmol) and toluene (16 m). The mixture was degassed for 15 min before bis[(tri-ortho-tolyl)phosphine]palladiumdichloride (11 mg, 1 mol%) was added and degassing continued for 15 min before a degassed 20% wt. solution of tetraethylammonium hydroxide in water (4 ml) was added and the mixture was vigorously stirred at 115°C with protection from light for 18 h.

Bromobenzene (0.1 ml) was added and stirring continued at 115°C for 1 h before benzeneboronic acid (100 mg) was added and stirring continued at 115°C for 1 h. After cooling, the grey mixture was added slowly to 300 ml of methanol to precipitate the crude polymer as grey fibres. The fibres were filtered and washed with methanol, water and more methanol.

The polymer was redissolved in toluene (20 ml) and a solution of N,N-diethyldithiocarbamic acid sodium salt (15 ml) was added and the mixture was stirred at 65°C for 16 h. The layers were separated and the aqueous layer was extracted with toluene. The combined organic layers were washed with dilute HCl solution, sodium acetate solution and twice with water before being passed through a celite 545 plug to yield a clear yellow solution. The solution was concentrated until it became viscous and was then added dropwise to methanol (350 ml) to precipitate the polymer as off-white fibres which were isolated by filtration and washed with methanol and acetone, 420 mg. Gel permeation chromatography against polystyrene showed an Mₙ of 11,191 and an M_{w} of 29,849.

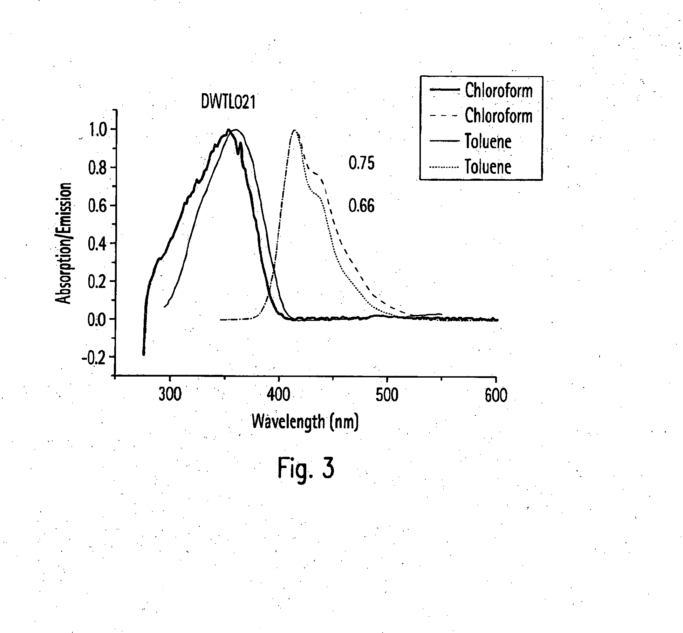

Photoluminescence of Polymer 1 was measured in a fluorometer in solution in toluene and in chloroform (emission peaks at around 410 nm). The results are displayed graphically in Figure 3.

### Example 2

### Synthesis of 50% fluorene - 50% Monomer 2 copolymer "Polymer 2" (Represented graphically in Figure 2).

A flask was charged with 9,9-dioctylfluorene-2,7-diboronic acid bis(1,3-propanediol) ester (400.0 mg, 99.50%, 0.713 mmol) and 3,7-dibromo-2,8-dihexyldibenzothiophene-S,S-dioxode (391.4 mg, 98.7%, 0.713 mmol) and toluene (16 m). The mixture was degassed for 15 min before bis[(tri-ortho-tolyl)phosphine]palladiumdichloride (11 mg, 1 mol%) was added and degassing continued for 15 min before a degassed 20% wt. solution of tetraethylammonium hydroxide in water (4 ml) was added and the mixture was vigorously stirred at 115°C with protection from light for 18 h. Bromobenzene (0.1 ml) was added and stirring continued at 115°C for 1 h before benzeneboronic acid (100 mg) was added and stirring continued at 115°C for 1 h. After cooling, the grey mixture was added slowly to 300 ml of methanol to precipitate the crude polymer as grey fibres. The fibres were filtered and washed with methanol, water and more methanol.

The polymer was redissolved in toluene (20 ml) and a solution of N,N-diethyldithiocarbamic acid sodium salt (15 ml) was added and the mixture was stirred at 65°C for 16 h. The layers were separated and the aqueous layer was extracted with toluene. The combined organic layers were washed with dilute HCl solution, sodium acetate solution and twice with water before being passed through a celite 545 plug to yield a clear yellow solution. The solution was concentrated until it became viscous and was then added dropwise to methanol (350 ml) to precipitate the polymer as off-white fibres which were isolated by filtration and washed with methanol and acetone, 503 mg. Gel permeation chromatography against polystyrene showed an Mₙ of 6,597 and an M_{w} of 14,791.

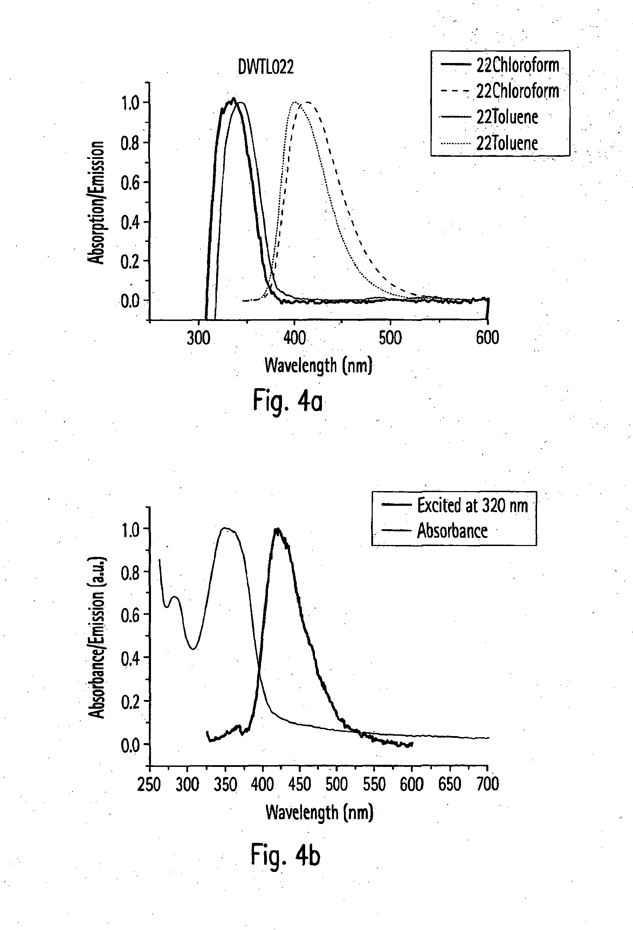

Photoluminescence of Polymer 2 was measured in a fluorometer in solution in toluene and in chloroform (emission peaks at around 410 nm and 415 nm respectively) and as a thin film on a quartz substrate, excited at 320 nm (emission at around 425 nm). The results are displayed graphically in Figures 4a (solution) and 4b (film).

Electronic devices were fabricated using Polymer 1 and Polymer 2.

### Example 3

An electroluminescent device was fabricated using a 1.1nm thick glass substrate coated with patterned indium tin oxide to give a sheet resistance of 15ohm/sq. The substrate was cleaned with detergent, deionized water, acetone and isopropanol successively in an ultrasonic bath, followed by UV ozone treatment for 10 minutes.

An approximately 50nm-thick layer of poly(3,4-ethylenedioxythiophene) poly(styrenesulfonate) (PEDOT) was spin coated first and then dried for 10 minutes on a hot-plate at 150°C. Polymer 1 was dissolved in toluene and spincoated onto the PEDOT layer to give a layer approximately 65nm thick. A 4nm thick layer of barium and then at least 100nm of aluminium were evaporated through a mask onto the polymer layer in a vacuum of approximately 1x10⁻⁶ mBar.

Four devices of 4mm x 5mm were obtained on a single substrate. The devices were sealed by using a UV curable epoxy resin to fix a piece of glass over the device area.

### Example 4

The method of Example 3 was repeated, replacing Polymer 1 with Polymer 2, to give four devices of 4mm x 5mm on a single substrate.

### Example 5

The method of Example 4 was repeated, however Polymer 2 was co-deposited with 10 w/w% of a green phosphorescent iridium complex as shown below, to give four devices of 4mm x 5mm on a single substrate.

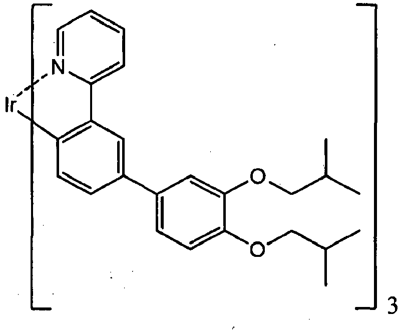

### Device Testing

The substrates of Examples 3, 4 and 5 were each placed in a sample holder where pins made electrical contact to the ITO anodes and barium/aluminium cathodes. The sample holder was mounted in an integrating sphere. The individual devices on each substrate could be selected via switches on the sample holder.

An Agilent 6632B power supply was used to drive the devices. Electroluminescence was measured using an Ocean Optics USB4000 CCD connected to the sphere with a fibre optic cable. The power supply and CCD were both controlled by a personal computer.

The voltage applied to the device was increased in uniform steps and the current and electroluminescence spectrum measured at each step. These values were then used to calculate quantities such as current density, external quantum efficiency, optical power output, wall plug efficiency, luminance, luminous efficacy, brightness and CIE co-ordinates.

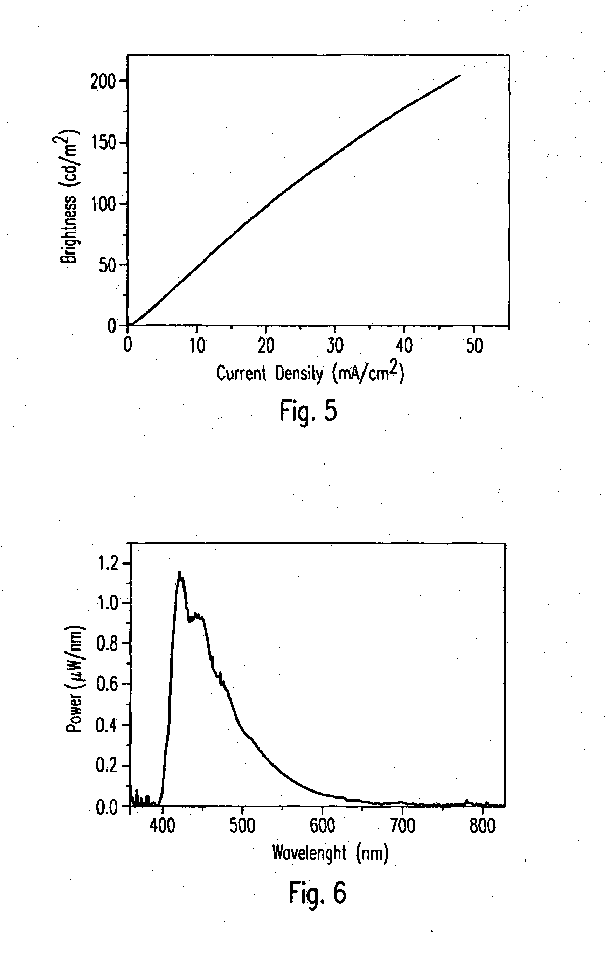

The results of some of these tests are shown in Figures 6 to 11.

As Figures 5 to 7 demonstrate, the device of Example 3 (containing Polymer 1) offers a powerful peak electroluminescent emission at around 425 nm (measured at 7V, 48mA/cm², 202cd/m²), thereby giving a deep blue emission, without detrimental effect on the device's on-voltage or brightness.

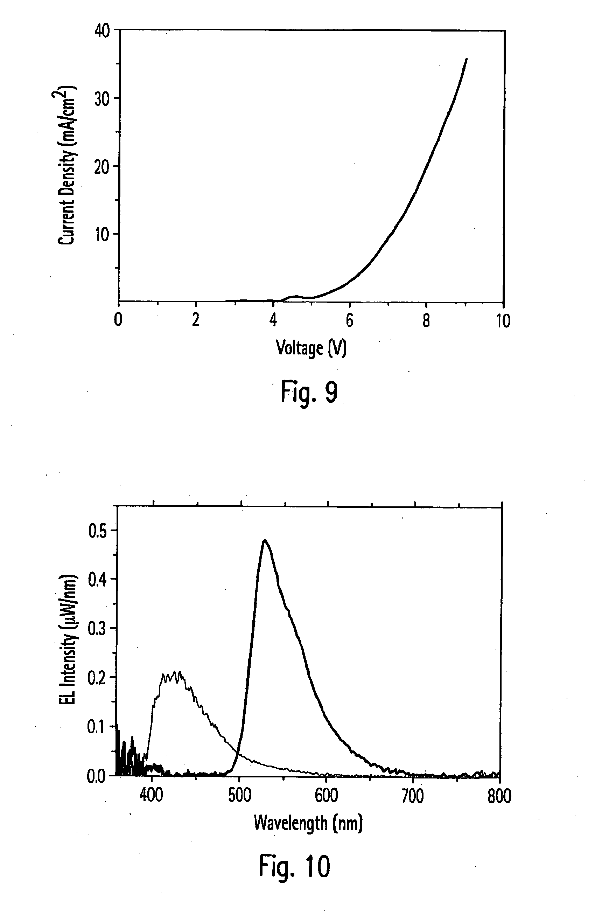

Figure 10 shows overlaid electroluminescent output of devices according to Examples 4 and 5, with Polymer 2 acting as a blue emitter at 425 nm in Example 4 (at 7V, 6.4mA/cm², 23cd/m²) and as a high energy triplet host in Example 5, which emits at around 530 nm (at 8V, 6.7mA/cm², 283cd/m²).

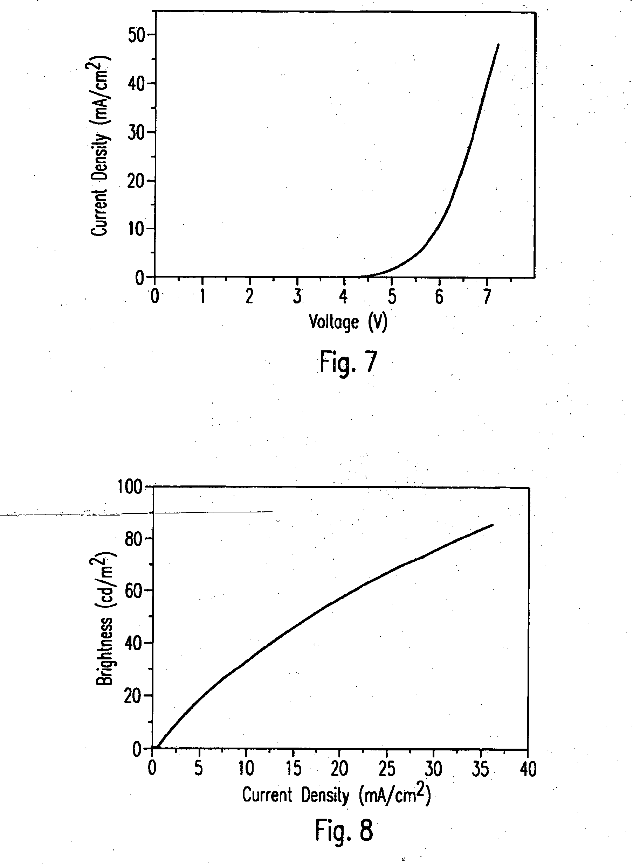

Figures 8 and 9, which display data for the device of Example 4 (containing Polymer 2), show that the device operates well within accepted ranges of voltages.

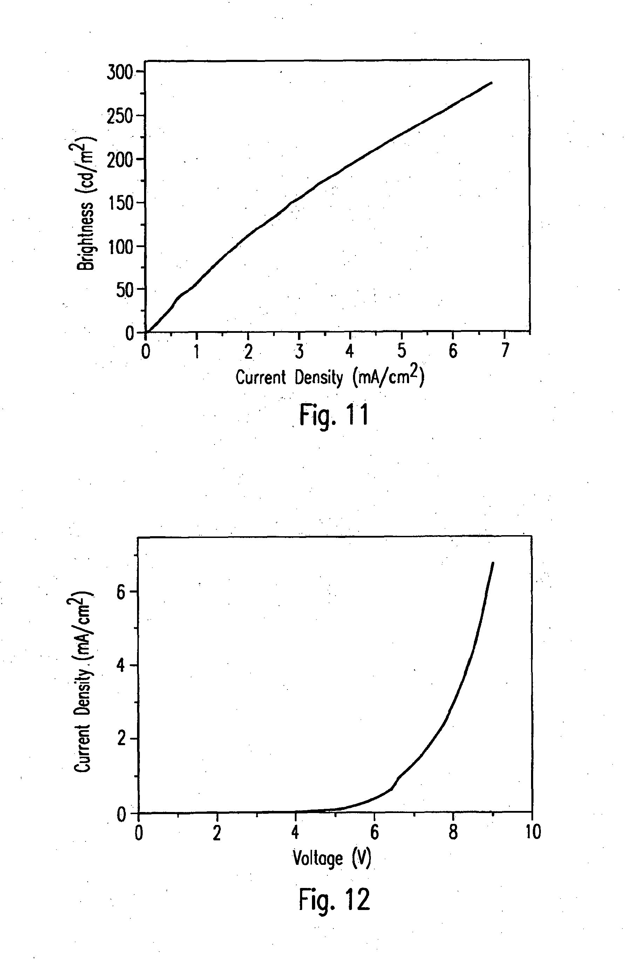

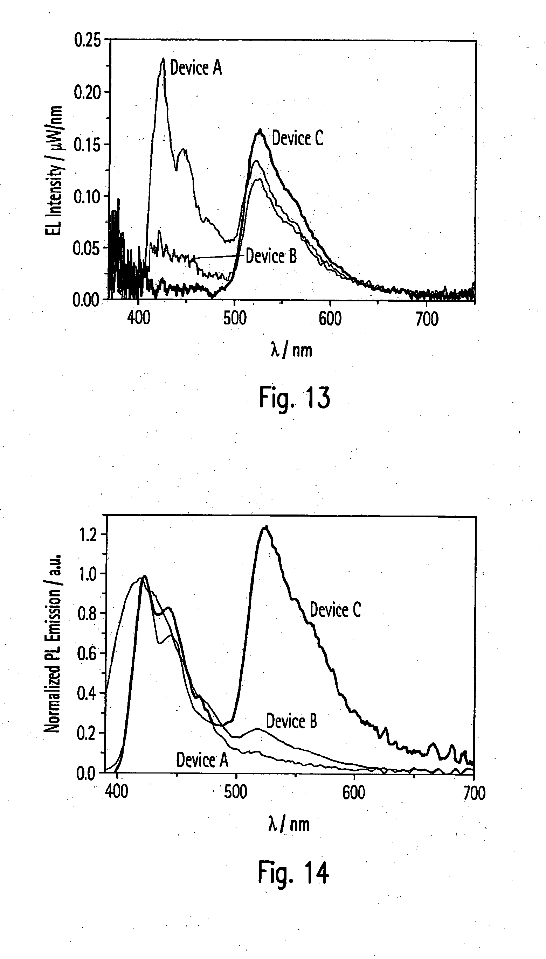

Figures 11 and 12, which display data for the device of Example 5 (containing Polymer 2 and the iridium complex), show that the device also operates well within accepted ranges of voltages.

No doubt many other effective alternatives will occur to the skilled person.

## Claims

1. An electroluminescent polymer comprising a first repeat unit comprising the structure: 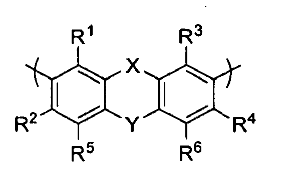 where R¹ to R⁶ are the same or different and comprise H or optionally substituted C₁ to C₂₆ straight or branched alkyl, alkenyl or alkynyl chains, or an optionally substituted C₁ to C₂₆ straight or branched alkoxy group; and wherein at least one of R¹ and R² and at least one of R³ and R⁴ is not H, where X comprises SO₂ and where Y comprises one of SO₂, NR⁸, CR9R¹⁰, S, SO, O or P, where R⁸ to R¹⁰ are the same or different and comprise H or optionally substituted C₁ to C₂₀ branched or cyclic alkyl, alkenyl or alkynyl chains or optionally substituted C₁ to C₂₀ aryl groups,
wherein the polymer comprises a second repeat unit comprising an organic semiconducting moiety, wherein the second repeat unit preferably comprises the structure: 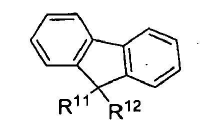 where R¹¹ and R¹² are the same or different and comprise H or an optionally substituted C₁ to C₂₀ straight, branched or cyclic alkyl, alkenyl or alkynyl chain, an optionally substituted C₁ to C₂₀ aryl group, an optionally substituted C₁ to C₂₀ straight, branched or cyclic alkoxy group, or amino, amido or hydroxyl groups, R¹¹ and R¹² being in particular C₈H₁₇.

2. An electroluminescent polymer according to Claim 1, wherein R⁵ and/or R⁶ are H.

3. An electroluminescent polymer according to any of Claims 1 to 2, wherein at least three of R¹ to R4 are not H.

4. An electroluminescent polymer according to any preceding Claim, wherein R¹ to R4, if not H, comprise C₁ to C₁₀ straight or branched alkyl alkenyl or alkynyl chains.

5. An electroluminescent polymer according to Claim 1, wherein the ratio of the number (y) of the first repeat units to the number (x) of the second repeat units is at least 15:85, preferably 30:70 and in particular 50:50.

6. An electroluminescent polymer according to any of Claims 1 to 5, wherein R⁴ and R⁵ comprise C₁ to C₁₀ unsubstituted straight alkyl chains.

7. An electroluminescent polymer according to any of Claims 1 to 6, wherein the second repeat unit is incorporated into the polymer backbone by para-coupling or meta-coupling.

8. An electroluminescent polymer according to any preceding Claim, further comprising at least one alkyne group, wherein the at least one alkyne group preferably can be situated between a first repeat unit and the or a second repeat unit or between two second repeat units.

9. An electroluminescent polymer according to any preceding Claim, wherein the polymer comprises a third repeat unit comprising an electron transport moiety, wherein preferably the polymer comprises a fourth different repeat unit comprising a hole transport moiety.

10. An electroluminescent polymer according to any preceding Claim, wherein the polymer comprises a block copolymer, regular or alternating copolymer or a random copolymer.

11. An electroluminescent polymer according to any preceding Claim, further comprising one or more red and/or green emitting repeat units, wherein the red and/or green emitting repeat units preferably comprise phosphorescent emitters.

12. An electroluminescent polymer according to any preceding Claim, wherein first repeat units comprise approximately 2 - 50 mole percent of the polymer, e.g. 10 - 35 mole percent or 20 - 30 mole percent of the polymer.

13. An electroluminescent polymer according to any preceding Claim, wherein at least a portion of the first repeat units functions as a blue emitting moiety.

14. An electroluminescent polymer according to any preceding Claim, wherein at least a portion of the first repeat units functions as an electron transporting moiety.

15. An electroluminescent polymer according to any preceding Claim, wherein at least a portion of the first repeat units functions as a high energy triplet host in the presence of one or more phosphorescent emitters, e.g. if the polymer comprises one or more phosphorescent emitters.

16. An electroluminescent polymer according to any preceding Claim, wherein the first repeat units and the second repeat units are selected such that they allow charge transfer therebetween in the excited state.

17. An electroluminescent polymer according to any preceding Claim, wherein the polymer is capable of emitting light close to white point (x,y = 0.33, 0.33).

18. An optical device comprising a polymer according to any preceding Claim, said optical device preferably comprising a red and/or green phosphorescent emitter.

19. An optical device according to Claim 18, wherein the optical device is an organic light emitting device whereby the polymer makes up at least part of an emissive layer, and wherein the organic light emitting device comprises first and second electrodes and the emissive layer is formed between the first and second electrodes.

20. An optical device according to Claim 19, comprising at least one further layer, including a hole injection layer or an electron injection layer.

## Patentansprüche

1. Elektrolumineszentes Polymer, eine erste Wiederholungseinheit umfassend, die Folgendes umfasst: 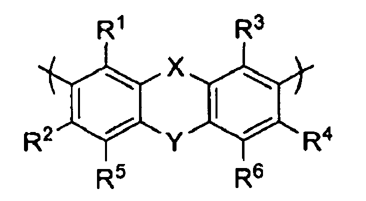 wobei R¹ bis R⁶ identisch oder verschieden sind und H oder optional substituierte gerade oder verzweigte C₁- bis C₂₆-Alkyl-, Alkenyl oder Alkynylketten oder eine optional substituierte gerade oder verzweigte C₁- bis C₂₆-Alkoxygruppe umfassen, und wobei mindestens eines von R¹ und R² und mindestens eines von R³ und R⁴ nicht H ist, wobei X SO₂ umfasst und wobei Y eines von SO₂, NR⁸, CR⁹R¹⁰, S, SO, O oder P umfasst, wobei R⁸ bis R¹⁰ identisch oder verschieden sind und H oder optional substituierte verzweigte oder zyklische C₁- bis C₂₀-Alkyl-, Alkenyl- oder Alkynylketten oder optional substituierte C₁- bis C₂₀-Arylgruppen umfassen,
wobei das Polymer eine zweite Wiederholungseinheit umfasst, die einen organischen halbleitenden Teil umfasst, wobei die zweite Wiederholungseinheit vorzugsweise folgende Struktur umfasst: 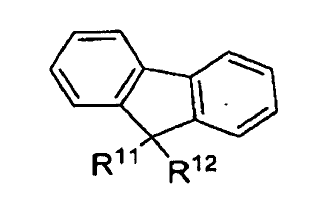 wobei R¹¹ und R¹² identisch oder verschieden sind und H oder eine optional substituierte gerade, verzweigte oder zyklische C₁- bis C₂₀-Alkyl-, Alkenyl oder Alkynylkette, eine optional substituierte C₁- bis C₂₀-Arylgruppe, eine optional substituierte gerade, verzweigte oder zyklische C₁- bis C₂₀-Alkoxygruppe oder Amino-, Amido oder Hydroxylgruppen umfassen, wobei R¹¹ und R¹² insbesondere C₈H₁₇ sind.

2. Elektrolumineszentes Polymer nach Anspruch 1, wobei R⁵ und/oder R⁶ H sind.

3. Elektrolumineszentes Polymer nach einem der Ansprüche 1 bis 2, wobei mindestens drei von R¹ bis R⁴ nicht H sind.

4. Elektrolumineszentes Polymer nach einem der vorhergehenden Ansprüche, wobei R¹ bis R⁴, wenn nicht H, so gerade oder verzweigte C₁- bis C₁₀-Alkyl-, Alkenyl oder Alkynylketten umfassen.

5. Elektrolumineszentes Polymer nach Anspruch 1, wobei das Verhältnis der Anzahl (y) der ersten Wiederholungseinheiten zur Anzahl (x) der zweiten Wiederholungseinheiten mindestens 15:85, vorzugsweise 30:70 und insbesondere 50:50 beträgt.

6. Elektrolumineszentes Polymer nach einem der Ansprüche 1 bis 5, wobei R⁴ und R⁵ unsubstituierte gerade oder verzweigte C₁- bis C₁₀-Alkylketten umfassen.

7. Elektrolumineszentes Polymer nach einem der Ansprüche 1 bis 6, wobei die zweite Wiederholungseinheit durch para-Kopplung oder meta-Kopplung in das Polymergrundgerüst eingearbeitet ist.

8. Elektrolumineszentes Polymer nach einem der vorhergehenden Ansprüche, ferner mindestens eine Alkingruppe umfassend, wobei die mindestens eine Alkingruppe vorzugsweise zwischen einer ersten Wiederholungseinheit und der oder einer zweiten Wiederholungseinheit oder zwischen zwei zweiten Wiederholungseinheiten angeordnet sein kann.

9. Elektrolumineszentes Polymer nach einem der vorhergehenden Ansprüche, wobei das Polymer eine dritte Wiederholungseinheit umfasst, die einen Elektronentransportteil umfasst, wobei das Polymer vorzugsweise eine vierte Wiederholungseinheit umfasst, die einen Lochtransportteil umfasst.

10. Elektrolumineszentes Polymer nach einem der vorhergehenden Ansprüche, wobei das Polymer ein Blockcopolymer, ein regelmäßiges oder alternierendes Copolymer oder ein statistisches Copolymer umfasst.

11. Elektrolumineszentes Polymer nach einem der vorhergehenden Ansprüche, ferner eine oder mehrere rot und/oder grün emittierende Wiederholungseinheiten umfassend, wobei die rot und/oder grün emittierenden Wiederholungseinheiten vorzugsweise phosphoreszierende Emitter umfassen.

12. Elektrolumineszentes Polymer nach einem der vorhergehenden Ansprüche, wobei erste Wiederholungseinheiten etwa 2 bis 50 Molprozent des Polymers ausmachen, beispielsweise 10 bis 35 Molprozent oder 20 bis 30 Molprozent des Polymers.

13. Elektrolumineszentes Polymer nach einem der vorhergehenden Ansprüche, wobei mindestens ein Anteil der ersten Wiederholungseinheiten als blau emittierender Teil fungiert.

14. Elektrolumineszentes Polymer nach einem der vorhergehenden Ansprüche, wobei mindestens ein Teil der ersten Wiederholungseinheiten als Elektrontransporteinheit fungiert.

15. Elektrolumineszentes Polymer nach einem der vorhergehenden Ansprüche, wobei mindestens ein Anteil der ersten Wiederholungseinheiten als energiereicher Triplett-Host in Gegenwart eines oder mehrerer phosphoreszierender Emitter fungiert, beispielsweise wenn das Polymer einen oder mehrere phosphoreszierende Emitter umfasst.

16. Elektrolumineszentes Polymer nach einem der vorhergehenden Ansprüche, wobei die ersten Wiederholungseinheiten und die zweiten Wiederholungseinheiten derart ausgewählt sind, dass sie im angeregten Zustand einen Ladungsübergang zwischen sich gestatten.

17. Elektrolumineszentes Polymer nach einem der vorhergehenden Ansprüche, wobei das Polymer in der Lage ist, Licht nahe am Weißpunkt (x,y=0,33,033) zu emittieren.

18. Optisches Bauelement, ein Polymer nach einem der vorhergehenden Ansprüche umfassend, wobei das optische Bauelement vorzugsweise einen rot und/oder grün phosphoreszierenden Emitter umfasst.

19. Optisches Bauelement nach Anspruch 18, wobei das optische Bauelement ein organisches lichtemittierendes Bauelement ist, wobei das Polymer mindestens einen Bestandteil der Emissionsschicht darstellt und wobei das organische lichtemittierende Bauelement eine erste und eine zweite Elektrode umfasst und die Emissionsschicht zwischen der ersten und der zweiten Elektrode gebildet ist.

20. Optisches Bauelement nach Anspruch 19, mindestens eine weitere Schicht umfassend, einschließlich einer Lochinjektionsschicht oder einer Elektroneninj ektionsschicht.

## Revendications

1. Polymère électroluminescent comprenant un premier motif de répétition comprenant la structure : 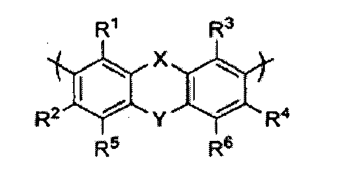 dans laquelle R¹ à R⁶ sont identiques ou différents et comprennent H ou des chaînes alkyle, alcényle ou alcynyle linéaires ou ramifiées en Ci à C₂₆ facultativement substituées, ou un groupe alcoxy linéaire ou ramifié en C₁ à C₂₆ facultativement substitué ; et dans laquelle au moins l'un de R¹ et R² et au moins l'un de R³ et R⁴ n'est pas H, où X comprend SO₂ et où Y comprend l'un de SO₂, NR⁸, CR⁹R¹⁰, S, SO, O ou P, où R⁸ à R¹⁰ sont identiques ou différents et comprennent H ou des chaînes alkyle, alcényle ou alcynyle ramifiées ou cycliques en C₁ à C₂₀ facultativement substituées ou des groupes aryle en C1 à C₂₀ facultativement substitués,
**caractérisé en ce que** le polymère comprend un deuxième motif de répétition comprenant un fragment semi-conducteur organique, le deuxième motif de répétition de préférence comprenant la structure : 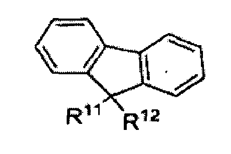 où R¹¹ et R¹² sont identiques ou différents et comprennent H ou une chaîne alkyle, alcényle ou alcynyle linéaire, ramifié ou cyclique en C₁ à C₂₀ facultativement substituée, un groupe aryle en C₁ à C₂₀ facultativement substitué, un groupe alcoxy linéaire, ramifié ou cyclique en C₁ à C₂₀ facultativement substitué, ou des groupes amino, amido ou hydroxyle, R¹¹ et R¹² étant en particulier C₈H₁₇.

2. Polymère électroluminescent selon la revendication 1, dans lequel R⁵ et/ou R⁶ sont H.

3. Polymère électroluminescent selon l'une quelconque des revendications 1 à 2, dans lequel au moins trois de R¹ à R⁴ ne sont pas H.

4. Polymère électroluminescent selon l'une quelconque des revendications précédentes, dans lequel R¹ à R⁴, s'ils ne sont pas H, comprennent des chaînes alkyle, alcényle ou alcynyle linéaires ou ramifiées en C₁ à C₁₀.

5. Polymère électroluminescent selon la revendication 1, dans lequel le rapport du nombre (y) des premiers motifs de répétition au nombre (x) des deuxièmes motifs de répétition est au moins 15:85, de préférence 30:70 et en particulier 50:50.

6. Polymère électroluminescent selon l'une quelconque des revendications 1 à 5, dans lequel R⁴ et R⁵ comprennent des chaînes alkyle linéaires non substituées en C₁ à C₁₀.

7. Polymère électroluminescent selon l'une quelconque des revendications 1 à 6, dans lequel le deuxième motif de répétition est incorporé dans le squelette du polymère par para-couplage ou méta-couplage.

8. Polymère électroluminescent selon l'une quelconque des revendications précédentes, comprenant en outre au moins un groupe alcyne, dans lequel l'au moins un groupe alcyne peut être de préférence situé entre un premier motif de répétition et le ou un deuxième motif de répétition ou entre deux deuxièmes motifs de répétition.

9. Polymère électroluminescent selon l'une quelconque des revendications précédentes, **caractérisé en ce que** le polymère comprend un troisième motif de répétition comprenant un fragment de transport d'électron, où, de préférence, le polymère comprend un quatrième motif de répétition différent comprenant un fragment de transport de lacune.

10. Polymère électroluminescent selon l'une quelconque des revendications précédentes, **caractérisé en ce que** le polymère comprend un copolymère séquencé, un copolymère régulier ou alterné ou un copolymère statistique.

11. Polymère électroluminescent selon l'une quelconque des revendications précédentes, comprenant en outre un ou plusieurs motifs de répétition à émission rouge et/ou verte, les motifs de répétition à émission rouge et/ou verte comprenant de préférence des émetteurs phosphorescents.

12. Polymère électroluminescent selon l'une quelconque des revendications précédentes, dans lequel les premiers motifs de répétition comprennent approximativement 2 à 50 pour cent en moles du polymère, par exemple 10 à 35 pour cent en moles ou 20 à 30 pour cent en moles du polymère.

13. Polymère électroluminescent selon l'une quelconque des revendications précédentes, dans lequel au moins une partie des premiers motifs de répétition fonctionne comme un fragment à émission bleue.

14. Polymère électroluminescent selon l'une quelconque des revendications précédentes, dans lequel au moins une partie des premiers motifs de répétition fonctionne comme un fragment de transport d'électron.

15. Polymère électroluminescent selon l'une quelconque des revendications précédentes, dans lequel au moins une partie des premiers motifs de répétition fonctionne comme un hôte de triplet à haute énergie en présence d'un ou plusieurs émetteurs phosphorescents, par exemple si le polymère comprend un ou plusieurs émetteurs phosphorescents.

16. Polymère électroluminescent selon l'une quelconque des revendications précédentes, dans lequel les premiers motifs de répétition et les deuxièmes motifs de répétition sont choisis de sorte qu'ils permettent le transfert de charge entre ceux-ci dans l'état excité.

17. Polymère électroluminescent selon l'une quelconque des revendications précédentes, **caractérisé en ce que** le polymère est capable d'émettre de la lumière proche du point blanc (x,y = 0,33,0,33).

18. Dispositif optique comprenant un polymère selon l'une quelconque des revendications précédentes, ledit dispositif optique comprenant de préférence un émetteur phosphorescent rouge et/ou vert.

19. Dispositif optique selon la revendication 18, **caractérisé en ce que** le dispositif optique est un dispositif électroluminescent organique dans lequel le polymère constitue au moins une partie d'une couche d'émission, et **en ce que** le dispositif électroluminescent organique comprend des première et deuxième électrodes et la couche d'émission est formée entre les première et deuxième électrodes.

20. Dispositif optique selon la revendication 19, comprenant au moins une couche supplémentaire, comprenant une couche d'injection de lacune ou une couche d'injection d'électron.
